# EUROPEAN PATENT APPLICATION

(11) **EP 2 096 680 A1**
(43) Date of publication of application: **02.09.2009**
(21) Application number: 07832339.1
(22) Date of filing: 22.11.2007
(51) Int. Cl.: H01L 31/042, B32B 27/28, B32B 27/36

(54) **SHEET FOR SEALING BACKSIDE OF SOLAR CELL AND SOLAR CELL MODULE**

(30) Priority: 27.11.2006 JP 2006318078
(71) Applicant: Toray Industries, Inc., Tokyo, 103-8666 (JP); Toray Advanced Film Co., Ltd., Chuo-ku Tokyo 103-0021 (JP)
(72) Inventor: HIROTA, Kusato, Otsu-shi Shiga 520-8558 (JP); ARAI, Takashi, Otsu-shi Shiga 520-8558 (JP); MIKAWA, Masahiro, Mishima-shi Shizuoka 411-0824 (JP)
(74) Representative: Kador & Partner
(86) International application number: PCT/JP2007/072610
(87) International publication number: WO 2008/069024

(57) **Abstract**

The present invention relates to a solar cell rear surface sealing sheet, wherein a laminate body including a compatible resin layer and an adhesive layer is provided on one surface of a polyester film so that the adhesive layer faces the polyester film, the compatible resin layer is made of a resin having compatibility with an ethylene-vinyl acetate copolymer resin, and the compatible resin layer has a thickness of 0.2 - 2 µm. According to the present invention, a solar cell rear surface sealing sheet having such favorable adhesive strength that is demanded as the solar cell rear surface sealing sheet to an ethylene-vinyl acetate copolymer filler layer and being excellent in storage stability and productivity of a film roll can be provided.

## Description

### TECHNICAL FIELD

The present invention relates to a solar cell rear surface sealing sheet superior in its mechanical strength such as tolerance for peel-off and resistance to environment, and a solar cell module using the same.

### BACKGROUND ART

In recent years, a solar cell has been rapidly becoming widespread as a clean energy. The solar cell module, in which a solar cell element such as a crystallized silicon solar cell element is used, is manufactured such that a surface protection sheet layer; a filler layer; the solar cell element as a photovoltaic element; a filler layer, a typical material of which is an ethylene-vinyl acetate copolymer; a rear surface sealing sheet; and the like are laminated, and a vacuum-suction typed heating lamination method, or the like, is applied thereto. As the rear surface sealing sheet constituting the solar cell module, a plastic sheet which has a small weight and a high strength is generally used. It is necessary that the rear surface sealing sheet to be excellent in its mechanical strength, weatherability, heat resistance, water resistance, light resistance, chemical resistance, and light reflection, and is also excellent in gas-barrier property from the viewpoint of preventing the invasion of moisture, oxygen and the like. A typical constitution is to provide a polyester film superior in its weather resistance and gas-barrier property (Patent Document 1). Generally, the adhesiveness between a polyester film, a typical material of which is a polyethylene terephthalate resin, and an ethylene-vinyl acetate copolymer resin is not so much high. Accordingly, as a countermeasure for improving adhesive strength, a constitution where a thermal adhesive layer (hot-melt adhesive layer) made of a styrene-olefin copolymer resin is provided has been proposed in order to improve the adhesiveness to the filler layer made of an ethylene-vinyl acetate copolymer (Patent Document 2).
Patent Document 1: Japanese Patent Application Laid-Open 2002-026354 ([0008] - [0010])
Patent Document 2: Japanese Patent Application Laid-Open 2003-060218 (see [0008] - [0010])

### DISCLOSURE OF THE INVENTION

### PROBLEMS TO BE SOLVED BY THE INVENTION

In order to obtain such favorable adhesive strength in the hot-melt thermal adhesive layer, however, it is necessary that the layer has a thickness of approximately 3 µm. Accordingly, a coating speed cannot be increased to make sure that the layer is fully dry. There are also other disadvantages, which are the increase of costs since a large number of coating materials are used, and the occurrence of pseudo adhering between layers (blocking) in a coated film roll during the summertime due to its relatively high tackiness.

In order to solve the problems of the conventional techniques described above, an object of the present invention is to provide a solar cell rear surface sealing sheet having such sufficient adhesive strength that is demanded as the solar cell rear surface sealing sheet to an ethylene-vinyl acetate copolymer filler layer and being excellent in storage stability and productivity of a film roll, and to preferably provide a solar cell rear surface sealing sheet also advantageous in its superior gas-barrier property and weatherability.

### MEANS FOR SOLVING THE PROBLEMS

In order to achieve the foregoing objects, the solar cell rear surface sealing sheet according to the present invention is constituted as follows. That is, a laminate body including a compatible resin layer and an adhesive layer is provided on one surface of a base polyester film so that the adhesive layer faces the polyester film, the compatible resin layer is made of a resin having compatibility with an ethylene-vinyl acetate copolymer resin, and the compatible resin layer has a thickness of 0.2 - 2 µm.

The solar cell module according to the present invention includes the solar cell rear surface sealing sheet according to the present invention, and a filler layer made of an ethylene-vinyl acetate copolymer resin, wherein the compatible resin layer of the solar cell rear surface sealing sheet and the filler layer are laminated so as to face each other.

### EFFECT OF THE INVENTION

According to the present invention, a solar cell rear surface sealing sheet having favorable adhesive strength to an ethylene-vinyl acetate copolymer filler layer, wherein the blocking can be prevented from occurring during transportation and storage in a rolled film state, can be provided.

### BEST MODE FOR CARRYING OUT THE INVENTION

The solar cell rear surface sealing sheet according to the present invention has a structure where an adhesion improvement layer for adhering to a filler layer made of an ethylene-vinyl acetate copolymer resin (hereinafter, referred to as an ethylene-vinyl acetate copolymer filler layer) constituting a solar cell module is provided on a base polyester film. The "adhesion improvement layer" is a layer provided to firmly bond the ethylene-vinyl acetate copolymer resin and the base polyester film each other. The present invention is **characterized in that** a laminate body including a compatible resin layer made of a resin having compatibility with an ethylene-vinyl acetate copolymer resin and an adhesive layer constitutes the adhesion improvement layer, and the adhesion improvement layer is provided on the base polyester film so that the adhesive layer of the adhesion improvement layer faces the base polyester film. According to such constitution, when the solar cell rear surface sealing sheet according to the present invention is used in the solar cell module, the compatible resin layer of the adhesion improvement layer can be in contact with the ethylene-vinyl acetate copolymer filler layer. When the adhesion improvement layer is thus provided, favorable adhesiveness to the ethylene-vinyl acetate copolymer filer layer and such favorable storage stability that prevents the occurrence of the blocking and sticking during the storage can be obtained.

The compatible resin layer according to the present invention preferably has compatibility with the ethylene-vinyl acetate copolymer resin and the compatibility generates at least a softening point of the ethylene-vinyl acetate copolymer resin. More specifically, the ethylene-vinyl acetate copolymer, or a copolymerized polymer including the ethylene-vinyl acetate copolymer as a basic structure and a third component such as an acrylic or methacrylic monomer is copolymerized therewith, can be used. A coating resin in which the ethylene-vinyl acetate copolymer is aqueously emulsified is advantageous in that an amount of the resin to be used can be reduced, since a highly productive coating step such as gravure coating can be adopted.

The adhesive layer according to the present invention is provided in order to improve the adhesiveness between the base polyester film and the adhesion improvement layer and further improve the adhesiveness between the base polyester film and the ethylene-vinyl acetate copolymer filler layer. When the base polyester film is directly adhered to the adhesion improvement layer, it is difficult to obtain desirable adhering strength, however, in a case where an adhesive layer adherent to both of the base polyester film and the adhesion improvement layer is interposed therebetween, the base polyester film and the adhesion improvement layer can be more closely bonded to each other. When the adhesive layer is thus interposed, favorable adhesiveness can be obtained even when a film which is easy to cleave, for example, a white polyester film, is used as the base polyester film. A conventionally known dry laminate adhesive can be used as the adhesive layer. In particular, urethane adhesives such as ether-based, polyester-based and polyol-based adhesives, which have superior adhesive strength to the base polyester film and also have superior isothermal stability and long-term durability in the adhesive strength, are preferably used. Regarding these examples, a polyester urethane-based adhesive is preferably used because it has low tackiness immediately after being applied and can be easily applied. Further, such an adhesive generally includes an isocyanate curing agent. An isocyanate group generates cross-linking reaction with an active hydrogen containing functional group such as a hydroxyl group included in the compatible resin layer, and therefore, it preferably contributes to the improvement of the adhesive strength between the adhesive layer and the compatible resin layer.

The base polyester film according to the present invention is preferably stretched because its strength, dimension stability and thermal stability can be thereby increased. A biaxially-stretched polyester film is particularly suitably used.

In a method for forming of the compatible resin layer and the adhesive layer, the well known wet coating such as a direct gravure coating method and a reverse gravure coating method can be adopted.

It is important to control a thickness of the compatible resin layer to be 0.2 - 2 µm and preferably 0.2 - 1 µm because good adhesive strength can be obtained, the cost of coating materials can be reduced, and a processing speed can be increased. In a case where the thickness of the compatible resin layer is smaller than 0. 2 µm, not only film discontinuity is easily generated in the film formation process, but also a portion of the layer having compatibility with the ethylene-vinyl acetate copolymer filler layer becomes thin, which makes it difficult to reliably obtain the adhesive strength. In a case where the thickness is larger than 2 µm, the coating speed cannot be increased because it is necessary to fully dry a coating material due to the large amount of the coating material, which not only deteriorates the productivity but also more easily generates the blocking during the storage.

The thickness of the adhesive layer is not particularly limited, however, it is preferably 0.1 µm or more and 1.5 µm or less. In a case where the thickness of the adhesive layer is smaller than 0.1 µm, film discontinuity may be generated in the film formation process, or the adhesive force between the base film and the compatible resin layer may not be reliably exerted in some cases. On the other hand, in a case where the thickness is larger than 1.5 µm, the tackiness of a coating film surface, which is a characteristic of the adhesive layer, is increased, and therefore, there may be problems in a manufacturing process, for example, the adhesive layer sticks to a carrier roll in some cases. In order to reliably exert the adhesive force and meet coating suitability, the thickness of the adhesive layer is preferably 0.2 µm or more and 0.5 µm or less.

In the solar cell rear surface sealing sheet according to the present invention, a transparent inorganic layer is preferably provided. When the transparent inorganic layer is provided, a high steam-barrier property can be obtained. More specifically, for example, a gas-barrier film such as an alumina-deposited film or a silica-deposited film is further provided with an adhesive interposed therebetween, or the base polyester film according to the present invention itself is made to be a gas-barrier polyester film such as an alumina-deposited polyester film or a silica-deposited polyester film.

Further, in the solar cell rear surface sealing sheet according to the present invention, a light reflection layer is preferably provided. When the light reflection layer is provided, power generation efficiency can be improved. Examples of a method for forming the light reflection layer include a mothod in which a white coating material is applied to the base polyester film, a method in which a white resin film is additionally provided, or a method in which the base polyester film according to the present invention itself is made to be a white polyester film. Reagarding these examples, it is preferable to additionally provide the white polyester film with an adhesive interposed therebetween because the material is at a low cost and high reflectivity can be obtained. The white polyester film is generally easy to cleave due to the influences of a pigment. However, according to the constitution of the present invention, favorable adhesiveness can be obtained even in a case where the white polyester film itself is used as the base polyester film. As the adhesive used in the laminate film on which the transparent inorganic layer is formed as described above and the white polyester film, a dry laminate adhesive in which, for example, a polyether urethane-based, polyester polyurethane-based, or polyester-based material is used as a main component and polyisocyanate is used as a current agent is preferably used in view of working efficiency.

In order to obtain superior weatherability, a weather resistant film such as a fluorine-based film or a weather resistant (hydrolysis resistant) biaxially-stretched polyester film is preferably provided on an outermost layer of the solar cell rear surface sealing sheet exposed to outdoor air.

As described earlier, in the solar cell rear surface sealing sheet according to the present invention, the surface of the compatible resin layer and the surface of the ethylene-vinyl acetate copolymer filler layer of the solar cell module are adhered to each other to form a laminate body, and thereby constituting the solar cell module. Below are listed examples of the laminate body in preferable aspects which can further enhance the effect (an adhesive layer between each of the following layers is not mentioned).
· adhesion improvement layer / white polyester film (base polyester film) / gas-barrier film / weather resistant film
· adhesion improvement layer / gas-barrier polyester film (base polyester film) / white weather resistant film
· adhesion improvement layer / transparent polyester film (base polyester film) / white weather resistant film
· adhesion improvement layer / white weather resistant polyester film (base polyester film)

### EXAMPLES

Next, a measuring method adopted in the present invention is described.

### (1) Measurement of Film Thickness

Referring to the film thicknesses of the compatible resin layer and the adhesive layer, a film provided with the adhesion improvement layer or a sheet to which the film and another film are stuck was cut perpendicular to a film surface with a cutter knife to obtain a small piece, and a sectional surface of the small piece was observed with a scan electronic microscope so that the film thicknesses of the compatible resin layer and the adhesive layer were measured. The film thicknesses were measured at three points in the sectional-surface portion of the small piece, and average values of the three measured thickness values thereby obtained were used as the film thicknesses.

### (2) Measurement of Adhesive Strength to Ethylene-vinyl acetate copolymer resin

Based on JIS K 6854-3 (1999), adhesive force to the ethylene-vinyl acetate copolymer resin was measured. A sample used for the measurement was obtained such that an ethylene-vinyl acetate copolymer film (manufactured by Mitsui Chemicals Fabro, Inc., film having a thickness of 0.7 mm) was laid on the surface of the adhesion improvement layer of the solar cell rear surface sealing sheet, and a semi-tempered glass having a thickness of 0.3 mm was further laid thereon, and then, the resulting laminate was pressed for 30 minutes under the heat conditions of 150°C and the load application of 3 Kg/cm². The width of a test piece was 10 mm, and an average value of a measurement results obtained from three test pieces was used as the adhesive strength. As far as the adhesive strength of at least 2 kgw/10 mm is obtained, there will be no problem in practical use.

### (3) Measurement of Blocking Shear Force

Two sheets of the solar cell rear surface sealing sheet were laid on each other in such a direction that the adhesion improvement layers thereof do not face each other (more specifically, adhesion improvement layer / base polyester film // adhesion improvement layer / base polyester film), and placed on a metal plate so that the surface of the base polyester film is in contact with the plate. A metal weight having a shape of rectangular solid in which a bottom surface had the dimension of 3 × 4 cm was placed on the two sheets and left in the environment at a temperature of 40°C for 65 hours, and the weight was thereafter removed. Each of the two sheets was stretched in opposing directions along a plane thereof (in the longitudinal direction of the bottom surface of the weight) so that shear force was measured. The measurement was performed on three test pieces, and an average value thereof was used as the shear force. The shear force results in 0 in a case that no blocking occurs, while the shear force shows a higher value as the blocking is increased. As far as the shear force obtained by the foregoing measuring method is at most 0.05 kgw, there will be no problem in practical use.

### EXAMPLE 1

As the base polyester film, an alumina-deposited polyester film in which alumina is deposited on one surface of a polyester film (Barrialox (registered trademark) 1011 HG-CR, thickness: 12 µm, manufactured by TORAY ADVANCED FILM Co., LTD.) was prepared. A polyester film surface of the alumina-deposited polyester film was coated with the following adhesive layer and compatible resin layer in this order as the adhesion improvement layer. These layers were applied by means of a tandem direct gravure coater having two heads under the following conditions.
· Adhesive layer: aromatic ester adhesive manufactured by Mitsui Chemicals Polyurethanes, Inc.
   main component: Takelac (registered trademark) A-310
   12 parts (liquid)
   curing agent: TAKENATE (registered trademark) A-3
   1 part (liquid)
   These two liquids were mixed.
   Coating conditions: solid portion: film thickness 0.3 µm drying conditions: 120°C, 4 seconds
· Compatible resin layer: AQUATEX (registered trademark) MC-3800 (ethylene-vinyl acetate copolymer emulsion) manufactured by CSC co., ltd.
   Coating conditions: solid portion: film thickness 1. 0 µm drying conditions: 125°C, 10 seconds

After a while, the transparent alumina-deposited polyester film and a white polyester film (Lumirror (registered trademark) E20, thickness: 50 µm, manufactured by Toray Industries, Inc.) were dry-laminated using an adhesive so that an alumina surface of the alumina deposited polyester film and a surface of the white polyester film faced each other. As the adhesive, an adhesive in which a commercially available polyester-based adhesive main component LX703VL (manufactured by DIC Corporation) and polyisocyanate curing agent KR90 (manufactured by DIC Corporation) were mixed at a ratio by weight of 15:1 (dry weight: 4g/m²) was used. Further, a weather resistant polyester film (Lumirror (registered trademark) X10S, thickness: 25 µm, manufactured by Toray Industries, Inc.) was further laminated on the white film with the same adhesive. As a result, the solar cell rear surface sealing sheet according to the present invention was obtained.

The adhesive strength to the ethylene-vinyl acetate copolymer resin was measured, and the blocking was evaluated. As shown in Table 1, such high adhesive strength was obtained, and the generation of the blocking was not observed.

### EXAMPLE 2

A white polyester film (Lumirror(registered trademark) E20, thickness: 50 µm, manufactured by Toray Industries, Inc.) was prepared as the base polyester film. The white polyester film was coated with the adhesive layer and the compatible resin layer as the adhesion improvement layer in a manner similar to Example 1.

After a while, the white polyester film and an alumina deposited polyester film (Barrialox (registered trademark) 1011 HG-CR, thickness: 12 µm, manufactured by TORAY ADVANCED FILM Co., LTD) were dry-laminated so that an alumina surface of the alumina deposited polyester film and a surface of the white polyester film faced each other with the same adhesive as that of Example 1. Further, a weather resistant polyester film (Lumirror (registered trademark) X10S, thickness: 25 µm, manufactured by Toray Industries, Inc.) was laminated on the alumina deposited polyester film with the same adhesive. As a result, the solar cell rear surface sealing sheet according to the present invention was obtained.

The adhesive strength to the ethylene-vinyl acetate copolymer resin was measured, and the blocking was evaluated. As shown in Table 1, such high adhesive strength was obtained, and the occurrence of the blocking was not observed.

### EXAMPLE 3

The solar cell rear surface sealing sheet constituted in the same manner as in Example 1 was obtained except that the film thickness of the solid portion of the compatible resin layer was changed to 2.0 µm in Example 1.

### EXAMPLE 4

The solar cell rear surface sealing sheet constituted in the same manner as in Example 1 was obtained except that the film thickness of the solid portion of the compatible resin layer was changed to 0.2 µm in Example 1.

### EXAMPLE 5

The solar cell rear surface sealing sheet constituted in the same manner as in Example 1 was obtained except that the film thickness of the solid portion of the adhesive layer was changed to 0.2 µm in Example 1.

### COMPARATIVE EXAMPLE 1

The solar cell rear surface sealing sheet constituted in the same manner as in Example 1 was obtained except that the adhesion improvement layer was made of the following resin and was formed under the following coating conditions in Example 1.
· Adhesion improvement layer: Styrene/olefin copolymer resin "Aronmelt" (registered trademark) PPET-1401SG (manufactured by TOAGOSEI CO., LTD.)

Coating conditions: The above resin was diluted with a mixture solvent of toluene/n-hexane = 4/1 (ratio by weight) to be 20 wt.%, and applied by a reverse coater, and the applied resin was dried at 120°C for 30 seconds so that the film thickness of the solid portion was 3.5 µm.

The adhesive strength to the ethylene-vinyl acetate copolymer resin was measured, and the blocking was evaluated. The adhesive strength shown in Table 1 was obtained, however, the blocking was generated.

### COMPARATIVE EXAMPLE 2

The solar cell rear surface sealing sheet constituted in the same manner as in Example 1 was obtained except that the adhesion improvement layer was not formed in Example 1.

The adhesive strength to the ethylene-vinyl acetate copolymer resin was measured, and the blocking was evaluated. As shown in Table 1, only low adhesive strength was obtained.

### COMPARATIVE EXAMPLE 3

The solar cell rear surface sealing sheet constituted in the same manner as in Example 1 was obtained except that the film thickness of the solid portion of the compatible resin layer was changed to 0.1 µm in Example 1.

### COMPARATIVE EXAMPLE 4

The solar cell rear surface sealing sheet constituted in the same manner as in Example 1 was obtained except that the film thickness of the solid portion of the compatible resin layer was changed to 3. 0 µm in Example 1. However, in a rolled sample thereby obtained, the blocking occurred in the compatible resin layer and an opposite surface of the base.

### Table 1

It is understood from the results of Examples 1, 3 and 4 that such adhesive strength that causes no problem in practical use can be obtained, and the occurrence of the blocking can be avoided in a case where the thickness of the compatible resin layer according to the present invention is in the range of 0.2 - 2.0 µm.

It is understood from the result of Example 2 that such adhesive strength that causes no problem in practical use can be obtained as far as the solar cell rear surface sealing sheet is constituted according to the present invention even in a case where the white polyester film, which is easy to cleave, is used as the base polyester film.

The sheet obtained in Comparative Example 1 was a sheet coated with the known adhesive resin. The sheet shows a certain degree of adhesive strength, however, it is not strong enough for practical use, and further, large shear force is generated and the blocking occurs when the sheet is rolled so that a rolling process is inapplicable.

The sheet obtained in Comparative Example 2 was a sheet not provided with either of the adhesive layer or the compatible resin layer. It was understood that the film thereby obtained could not achieve the adhesive strength to the ethylene-vinyl acetate copolymer resin.

In the sheet obtained in Comparative Example 3, the compatible resin layer was as thin as 0.1 µm, and cissing and irregularity were generated in the coating film. Therefore, it was not possible to obtain sufficient adhesive strength.

In the sheet obtained in Comparative Example 4, the compatible resin layer was as thick as 3. 0 µm, and not only costs were high but also the shear force of the coating film was increased. Accordingly, the blocking occurs when the sheet is rolled.

### INDUSTRIAL APPLICABILITY

The solar cell rear surface sealing sheet according to the present invention can be suitably used as a rear surface sealing sheet in a solar cell module. Besides the purpose, the sheet can also be suitably used as a sealing sheet for which good adhesiveness to an ethylene-vinyl acetate copolymer resin is demanded.

## Claims

1. A solar cell rear surface sealing sheet, wherein a laminate body comprising a compatible resin layer and an adhesive layer is provided on one surface of a base polyester film so that the adhesive layer faces the polyester film, the compatible resin layer is made of a resin having compatibility with an ethylene-vinyl acetate copolymer resin, and the compatible resin layer has a thickness of 0.2 - 2 µm.

2. The solar cell rear surface sealing sheet as claimed in Claim 1, wherein a resin constituting said compatible resin layer is an ethylene-vinyl acetate copolymer or a copolymer including the ethylene-vinyl acetate copolymer as a basic structure.

3. The solar cell rear surface sealing sheet as claimed in Claim 1 or 2, wherein a urethane adhesive constitutes said adhesive layer.

4. A solar cell module, comprising:
the solar cell rear surface sealing sheet claimed in any of Claims 1 - 3; and
a filler layer made of an ethylene-vinyl acetate copolymer resin, wherein
the compatible resin layer of the solar cell rear surface sealing sheet and the filler layer are laminated so as to face each other.
